**Europäisches Patentamt**

**European Patent Office**

**Office européen des brevets**

(11) Veröffentlichungsnummer : **0 039 076**
**B1**

# EUROPÄISCHE PATENTSCHRIFT

(45) Veröffentlichungstag der Patentschrift :
28.08.85

(51) Int. Cl.⁴ : **G 06 G  7/186, H 03 F  3/72//**
**H03H19/00**

(21) Anmeldenummer : 81103148.3

(22) Anmeldetag : 27.04.81

(54) **Integratorschaltung mit Abtaststufe.**

(30) Priorität : 30.04.80 DE 3016737

(43) Veröffentlichungstag der Anmeldung :
04.11.81 Patentblatt 81/44

(45) Bekanntmachung des Hinweises auf die Patenterteilung : 28.08.85 Patentblatt 85/35

(84) Benannte Vertragsstaaten :
AT BE CH DE FR GB IT LI LU NL SE

(56) Entgegenhaltungen :
DE-A- 2 629 415
US-A- 4 138 649
NUCLEAR INSTRUMENTS AND METHODS, Band 80, Nr. 1, 1. April 1970, Seiten 172-174 Amsterdam, NL. A. BATTISTA: "A simple, high performance linear gate for nuclear physics applications"
IEEE JOURNAL OF SOLID-STATE CIRCUITS, Band SC-12, Nr. 6, Dezember 1977, Seiten 600-608 New York, U.S.A. B.J. HOSTICKA et al.: "MOS sampled data recursive filters using switched capacitor integrators"

(73) Patentinhaber : **Siemens Aktiengesellschaft**
**Berlin und München Wittelsbacherplatz 2**
**D-8000 München 2 (DE)**

(72) Erfinder : **Klar, Heinrich, Dr. Dipl.-Ing.**
**Rossmarkt 8**
**D-8000 München 2 (DE)**
Erfinder : **Rössler, Bernward, Dipl.-Ing.**
**Franz-Reber-Weg 6**
**D-8000 München 71 (DE)**

## Beschreibung

Die Erfindung bezieht sich auf eine Integratorschaltung nach den Oberbegriffen der Patentansprüche 1 und 2.

Eine solche Integratorschaltung, bei der niederfrequente, insbesondere von den eingangsseitigen Verstärkerstufen herrührende Rauschspannungsanteile (1/f-Rauschen) weitgehend unterdrückt werden, ist aus der US-A-4 138 649 bekannt. Dabei werden diese Rauschspannungsanteile dadurch unterdrückt, daß sie in der im Rückkopplungszweig enthaltenen Kapazität während einer Umpolungshalbperiode aufintegriert, in der nächstfolgenden Umpolungshalbperiode jedoch wieder subtrahiert werden.

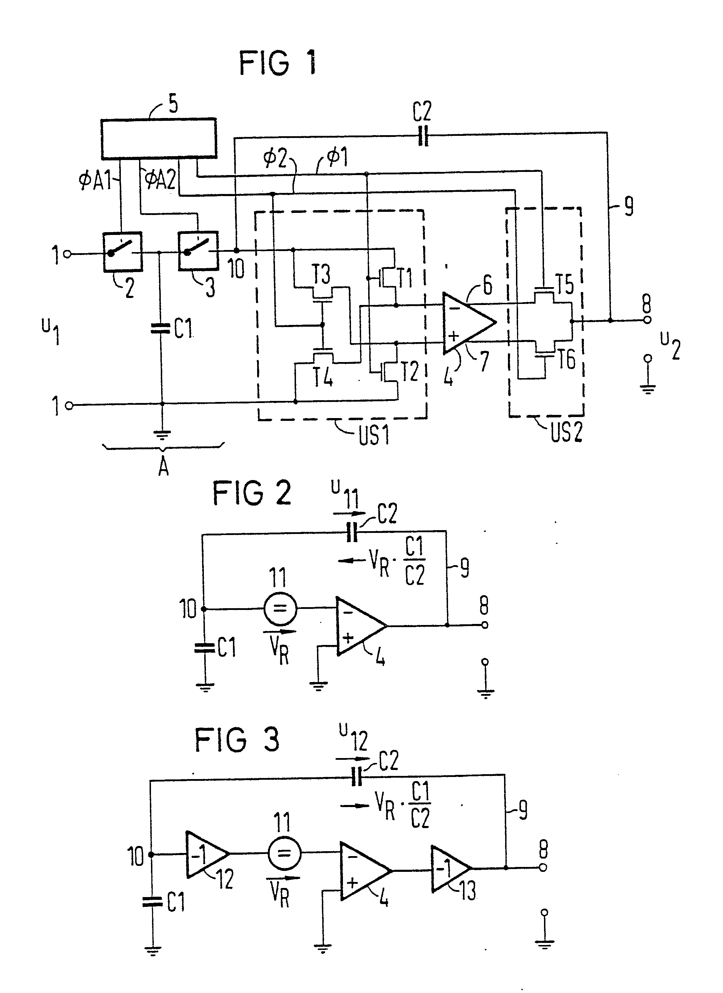

Aus dem IEEE Journal of Solid-State Circuits, Vol. SC-12, No. 6, Dez. 1977, Seiten 600 bis 608, insbesondere Fig. 2(b) ist andererseits eine Integratorschaltung bekannt, die ein zu integrierendes Eingangssignal mittels einer getakteten Kondensatorschaltung periodisch abtastet. Bei diesem Integrator wird das Integrationsergebnis durch Rauschspannungsanteile, die innerhalb der einzelnen Abtastperioden der im Rückkopplungszweig liegenden Kapazität zugeführt werden, erheblich verfälscht.

Der Erfindung liegt die Aufgabe zugrunde, die Betriebsweise von Integratorschaltungen der eingangs genannten Art zu verbessern und den Schaltungsaufwand zu verringern. Das wird erfindungsgemäß durch eine Ausbildung der eingangs genannten Integratorschaltung gemäß den kennzeichnenden Teilen des Patentanspruchs 1 oder des Patentanspruchs 2 erreicht.

Vorteilhafte Ausgestaltungen und Weiterbildungen der Erfindung sind in den Ansprüchen 3 und 4 angegeben.

Die Erfindung wird nachfolgend anhand der Zeichnung näher erläutert. Dabei zeigt :

Figur 1 eine Integratorschaltung nach dem Oberbegriff der Patentansprüche 1 und 2,

Figur 2 und Figur 3 Ersatzschaltbilder zur Erläuterung von Fig. 1,

Figur 4 Spannungs-Zeit-Diagramme zur Erläuterung von Fig. 1,

Figur 5 das Prinzipschaltbild einer solchen Integratorschaltung mit zwei Verstärkerstufen,

Figur 6 eine Teilschaltung von Fig. 5,

Figur 7 ein erstes Ausführungsbeispiel der Erfindung und

Figur 8 ein zweites Ausführungsbeispiel der Erfindung.

In Figur 1 wird eine am Eingang 1 anliegende, zu integrierende Signalspannung $u_1$ über einen ersten elektronischen Schalter 2 einer Kapazität C1 zugeführt, wobei diese auf den im Abtastzeitpunkt vorliegenden Signalwert aufgeladen wird. Nach dem Öffnen des Schalters 2 wird dann ein elektronischer Schalter 3 geschlossen, wodurch der in C1 gespeicherte Signalwert an die Eingänge eines Operationsverstärkers 4 gelangt, der als Differenzverstärker ausgebildet ist. Dabei wird der obere Anschluß von C1 über einen leitend geschalteten Feldeffekttransistor T1 mit dem negativen Eingang von 4 verbunden, während der untere, auf Bezugspotential liegende Anschluß von C1 über einen leitend geschalteten Feldeffekttransistor T2 an den positiven Eingang von 4 gelegt wird. T1 und T2 werden durch eine von einem Taktspannungserzeuger 5 gelieferte, den Gateelektroden zugeführte Taktspannung Ø1 leitend geschaltet. Zwei Feldeffekttransistoren T3 und T4 verbinden über ihre Source-Drain-Strecken die Anschlüsse von T1 mit den Eingängen von 4 in einer solchen Weise, daß der in C1 gespeicherte Signalwert gegenüber dem zuerst betrachteten Fall umgepolt wird. Dabei werden sie von einer an 5 abgreifbaren Taktspannung Ø2 leitend geschaltet. Die elektronischen Schalter 2 und 3, die ebenfalls aus Feldeffekttransistoren bestehen können, werden durch Taktspannungen ØA1 und ØA2 betätigt.

Die Teile 2, 3 und C1, die eine das Eingangssignal $u_1$ periodisch abtastende Stufe A bilden, werden in der Literatur hauptsächlich als eine « switched capacitor »-Schaltung bezeichnet. Die Transistoren T1 bis T4 stellen einen der Abtaststufe A nachgeordneten Polaritätsumschalter US1 dar.

Der Differenzverstärker 4 weist einen negativen Ausgang 6 und einen positiven Ausgang 7 auf, an denen jeweils Spannungen mit unterschiedlichen Vorzeichen gegenüber dem Bezugspotential auftreten. Dabei ist der Ausgang 6 über einen leitend geschalteten Feldeffekttransistor T5 mit dem Ausgang 8 der Integratorschaltung verbunden während der Ausgang 7 über einen leitend geschalteten Feldeffekttransistor T6 auf den Ausgang 8 durchgeschaltet wird. Die wechselweise leitend geschalteten Transistoren T5 und T6 stellen einen zweiten Polaritätsumschalter US2 dar. Ein Rückkopplungszweig 9, der die Integrationskapazität C2 enthält, ist zwischen den Ausgang 8 und den Ausgang 10 der Abtaststufe A geschaltet.

Die Wirkungsweise der Integratorschaltung nach Figur 1 sei zunächst mit Hilfe der Figuren 2 und 3 erläutert. Figur 2 zeigt ein Ersatzschaltbild für den Fall, daß der Schalter 3 geschlossen ist und die Transistoren T1, T2 und T5 jeweils leitend geschaltet sind. Die von dem Operationsverstärker 4 herrührenden Rauschspannungen werden durch eine Ersatzspannungsquelle 11 angedeutet, die in Serie zu dem negativen Eingang von 4 liegt. Dabei sei der Zeitraum, in dem das Erstzschaltbild in Figur 2 gilt, so kurz, daß sich die Rauschspannungen innerhalb desselben nicht wesentlich ändern, so daß 11 als Gleichspannungsquelle aufgefaßt werden kann, die eine Spannung $V_R$ abgibt. Die Spannungsquelle 11 erzwingt nun eine Aufladung von C1. Dabei fließt ein kapazitiver Ladestrom über C2, der diese Kapazität auf die Spannung $V_R \cdot (C1/C2)$ mit einer durch den Pfeil angedeuteten Polarität auflädt. Gleichzeitig wird ein in C1 gespeicherter

Abtastwert $u_{11}$ der Signalspannung $u_1$ mit der eingezeichneten Polarität auf C2 übertragen.

Das Ersatzschaltbild für den Fall, daß der Schalter 3 geschlossen ist und die Transistoren T3, T4 und T6 leiten, während T1, T2 und T5 gesperrt sind, stellt Figur 3 dar. Die zu Figur 2 jeweils entgegengesetzten Schaltstellungen der Polaritätsumschalter US1 und US2 werden durch die eingezeichneten Inverter 12 und 13 berücksichtigt. Nimmt man an, daß sich die Rauschspannung $V_R$ in dem der Figur 3 entsprechenden Zeitraum nicht wesentlich gegenüber Figur 2 verändert, so kann dieselbe Ersatzspannungsquelle 11 zugrundegelegt werden wie in Figur 2. Es erfolgt wieder eine Aufladung von C2 durch den Rauschspannungsanteil $V_R \cdot (C1/C2)$, jedoch wegen des Inverters 13 nunmehr mit der Figur 3 eingezeichneten Polarität, die zu der gemäß Figur 2 entgegengesetzt ist. Ein in C1 gespeicherter Abtastwert $u_{12}$, der sich nur wenig von $u_{11}$ unterscheiden soll, jedenfalls aber dieselbe Polarität aufweisen muß wie $u_{11}$, wird mit der eingezeichneten Polarität auf C2 übertragen, die wegen der sich gegenseitig kompensierenden Einflüsse der Inverter 12 und 13 der Polarität von $u_{11}$ in Figur 2 entspricht.

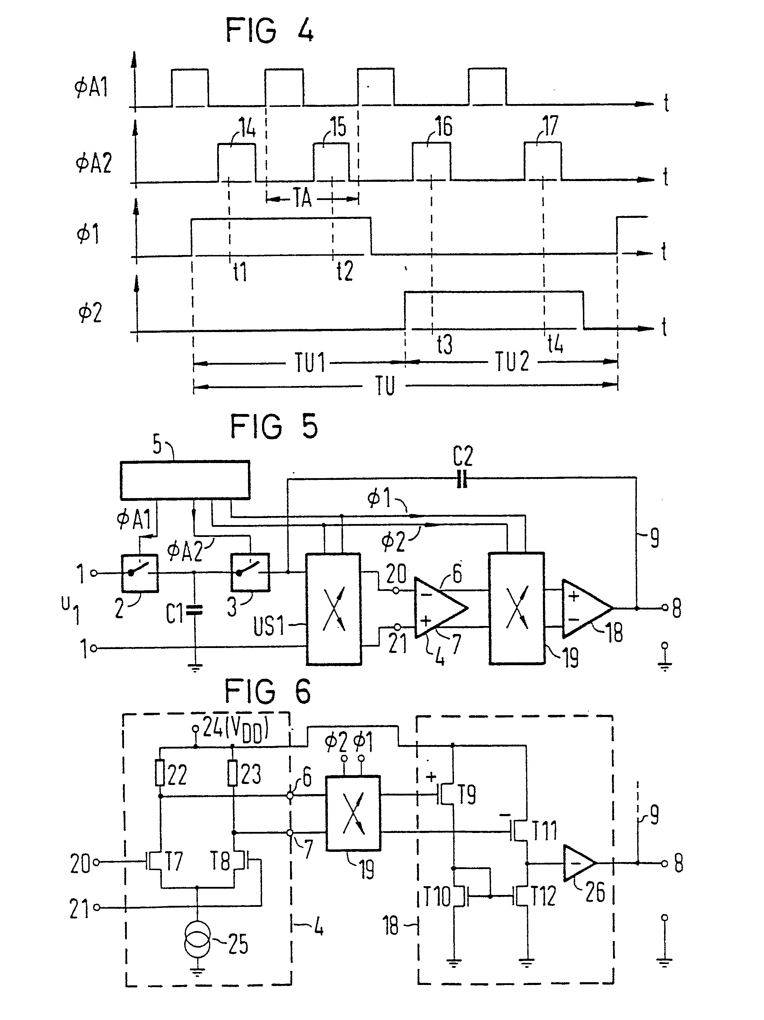

Mit den der Figur 4 entnehmbaren Zeitabhängigkeit der Taktspannung $\emptyset$ A1, $\emptyset$ A2, $\emptyset$ 1 und $\emptyset$ 2 entspricht Figur 2 jeweils den Umladungsvorgängen zu den Zeitpunkten t1 und t2, während Figur 3 den Umladungsvorgängen zu den Zeitpunkten t3 und t4 entspricht.

Eine Abtastperiode ist in Figur 4 mit TA bezeichnet, eine Umpolungsperiode mit TU. Letztere ist in eine erste Halbperiode TU1 und eine zweite Halbperiode TU2 unterteilt. Ändert sich innerhalb einer Periode TU die Rauschspannung des Verstärkers 4 nur unwesentlich, so wird die Kapazität C2 bei einem Taktschema nach Figur 4 während TU1 auf eine Rauschspannungskomponente $V_R \cdot (C1/C2)$ aufgeladen und innerhalb TU2 mit einer Rauschspannungskomponente beaufschlagt, die denselben Betrag, aber eine entgegengesetzte Polung hat, so daß innerhalb der gesamten Periode TU eine weitgehende Kompensation des Rauschspannungseinflusses erfolgt. Andererseits tritt innerhalb einer periode TU eine Summierung der jeweils innerhalb der einzelnen Abtastperioden TA in der Kapazität C1 gespeicherten Abtastwerte der Signalspannung $u_1$ ein. So werden gemäß Figur 4 innerhalb von TU1 während des Auftretens der Taktimpulse 14 und 15 insgesamt zwei Abtastwerte $u_{11}$ auf C2 übertragen und innerhalb von TU2 während des Auftretens der Taktimpulse 16 und 17 insgesamt zwei Abtastwerte $u_{12}$. Damit addieren sich in jeder Umpolungsperiode TU vier Abtastwerte der Signalspannung $u_1$ zu einer in C2 und damit auch am Ausgang 8 auftretenden Integralspannung $u_2$, während die Rauschspannungseinflüsse weitgehend unterdrückt werden. Wählt man abweichend von Figur 4 das Größenverhältnis von TA : TU zu 1 : n, wobei n = 1, 2, 3, 5 usw., so summieren sich in einer Umpolungsperiode TU jeweils n Abtastwerte von $u_1$, während die in den ersten Halbperioden TU1 den Abtastwerten jeweils hinzugefügten Rauschspannungsanteile in den zweiten Halbperioden TU2 wieder subtrahiert werden. Voraussetzung hierfür ist jedoch, daß es sich um Rauschspannungen handelt, deren Frequenzen hinreichend weit unterhalb der Umpolungsfrequenz 1/TU liegen. Das ist beispielsweise für das sogenannte 1/f-Rauschen von Operationsverstärkern der Fall, dessen Frequenzen im wesentlichen unterhalb von 10 kHz liegen. Die Abtastfrequenz 1/TA kann etwa 200 kHz betragen während der Frequenzbereich der Signalspannung $u_1$ eine obere Grenze von etwa 5 kHz aufweist. Damit ergibt sich eine Umpolungsfrequenz von beispielsweise 10 bis 100 kHz.

Figur 5 zeigt ein erfindungsgemäßes Ausführungsbeispiel, das sich von Figur 1 dadurch unterscheidet, daß neben dem Differenzverstärker 4 noch eine Differenzverstärkerstufe 18 vorgesehen ist, die einen einzigen einpolig auf Bezugspotential liegenden Ausgang aufweist. Die Eingänge der Differenzverstärkerstufe 18 sind mit den Ausgängen 6 und 7 von 4 über einen Polaritätsumschalter 19 verbunden der entsprechend US1 aufgebaut ist.

Der Schaltungsteil, der in Figur 5 zwischen den Eingängen 20, 21 des Differenzverstärkers 4 und dem Ausgang 8 der Integratorschaltung liegt, ist in Figur 6 mehr im Detail dargestellt. Der Differenzverstärker 4 enthält zwei Feldeffekttransistoren T7 und T8, deren Gateelektroden mit den Eingängen 20 und 21 verbunden sind. Ihre Drain-Anschlüsse sind über Lastelemente 22 und 23 an einen Anschluß 24 geführt, der mit einer Versorgungsspannung $V_{DD}$ beschaltet ist. Die miteinander verbundenen Source-Anschlüsse sind mit einer Konstantstromquelle 25 beschaltet, die einpolig auf Bezugspotential liegt. Der negative Ausgang 6 ist mit dem Verbindungspunkt zwischen den Teilen 22 und T7 verbunden, der positive Ausgang 7 mit dem Verbindungspunkt zwischen den Teilen 23 und T8. Die Lastelemente 22 und 23 können als Schichtwiderstände realisiert sein oder z. B. aus Feldeffekttransistoren bestehen, deren Gateelektroden mit ihren Sourceanschlüssen verbunden sind.

Die Differenzverstärkerstufe 18 enthält einen Feldeffekttransistor T9, dessen Gateanschluß den positiven Eingang darstellt. Der Drainanschluß von T9 ist mit dem Anschluß 24 verbunden während der Sourceanschluß über die Source-Drain-Strecke eines Feldeffekttransistors T10 auf Bezugspotential gelegt ist. Die Gate- und Drain-Anschlüsse von T10 sind miteinander verbunden. Der negative Eingang von 18 wird durch den Gateanschluß eines weiteren Feldeffekttransistors T11 gebildet, dessen Drainanschluß mit dem Anschluß 24 verbunden ist. Der Sourceanschluß von T11 ist über die Source-Drain-Strecke eines Feldeffekttransistors T12 an das Bezugspotential geschaltet, wobei das Gate von T12 mit dem Gate von T10 verbunden ist. Der Verbindungspunkt der Source-Drain-Strecken von T11 und T12 ist über einen Inverter 26 an den Ausgang 8 der Integratorschaltung gelegt.

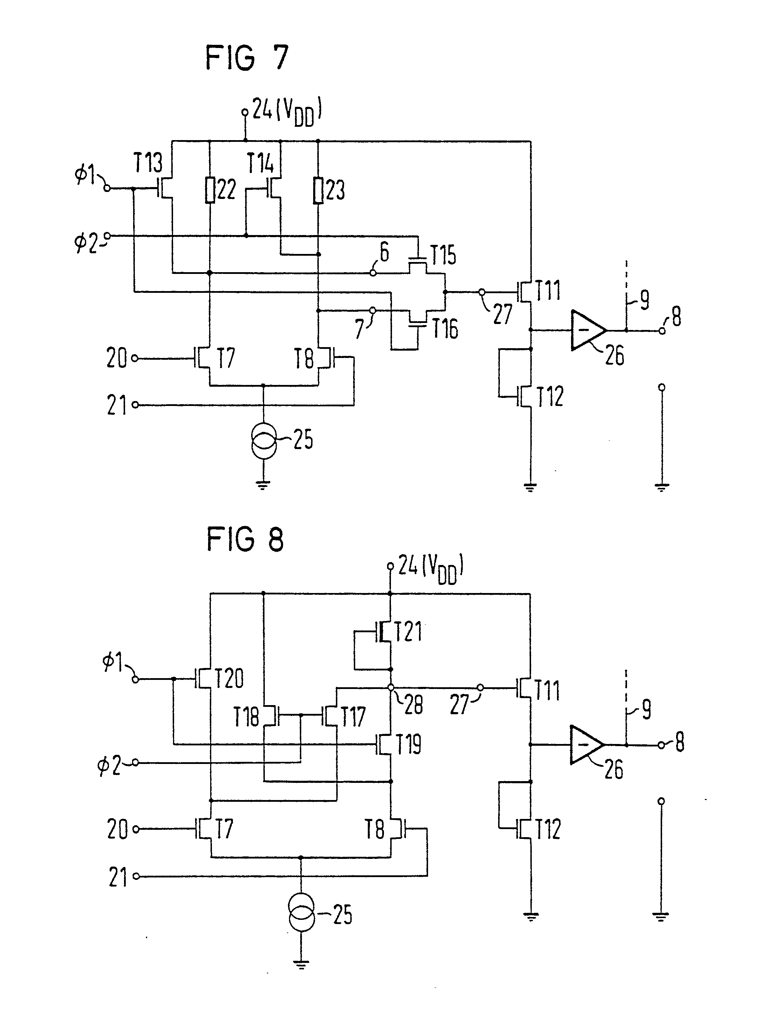

Das erfindungsgemäße Ausführungsbeispiel nach Figur 7 unterscheidet sich von dem nach Figur 6 dadurch, daß parallel zu den Lastelementen 22 und 23 jeweils Feldeffekttransistoren T13 und T14 angeordnet sind, deren Gateanschlüsse jeweils mit den Taktspannungen Ø1 und Ø2 beschaltet sind. Zwischen den negativen Ausgang 6 des Differenzverstärkers 4 und den Gateanschluß 27 von T11 ist ein Feldeffekttransitor T15 geschaltet, zwischen den positiven Ausgang 7 von 4 und den Gateanschluß 27 ein Feldeffekttransitor T16. Dabei werden an die Gateanschlüsse von T15 und T16 jeweils die Spannungen Ø2 und Ø1 angelegt. Die Transistoren T9 und T10 sind hierbei weggelassen und die Gate- und Drain-Anschlüsse von T12 miteinander verbunden. Beim Auftreten jedes Spannungsimpulses der Taktspannung Ø2 wird der Ausgang 6 über T15 an den Anschluß 27 durchgeschaltet, wobei gleichzeitig das Lastelement 23 überbrückt wird, während beim Auftreten jedes Spannungsimpulses der Taktspannung Ø1 der Ausgang 7 über T16 mit dem Anschluß 27 verbunden und das Lastelement 22 überbrückt wird. Durch die Ausgestaltung gemäß Figur 7 kann das Einschwingverhalten der Integratorschaltung verbessert werden.

Figur 8 zeigt schließlich eine Weiterbildung der Schaltung nach Figur 7, bei der der aus T15 und T16 bestehende Polaritätsumschalter und die Transistoren T13 und T14 durch die im Differenzverstärker vorgesehenen Feldeffekttransistoren T17 bis T20 ersetzt sind. Die beiden Lastelemente 22 und 23 sind in Figur 8 durch ein einziges Lastelement ersetzt, das aus einem Feldeffekttransistor T21 des Verarmungstyps besteht, dessen Gate- und Source-Anschluß miteinander verbunden sind. Beim Auftreten jedes Spannungsimpulses der Taktspannung Ø2 ist das Last-element T21 über den leitend geschalteten Transistor T17 zu dem Transistor T7 in Serie geschaltet, während der Drainanschluß des Transistors T8 über den Transistor T18 mit dem Anschluß 24 verbunden ist. Damit übernimmt der Schaltungspunkt 28 die Funktion des Ausgangs 6 von Figur 7. Tritt dagegen ein Spannungsimpuls der Taktspannung Ø1 auf, so wird T21 über T19 in Serie zu T8 geschaltet, während T7 über T20 mit dem Anschluß 24 verbunden ist. In diesem Fall entspricht der Schaltungspunkt 28 dem Ausgang 7 von Figur 7. Bei dieser Ausgestaltung kann der Schaltpunkt 28 ohne Änderung der Betriebsweise des Integrators unmittelbar mit dem Anschluß 27 verbunden werden.

Die Verstärkerstufen 4 und/oder 18 können im Rahmen der Erfindung auch durch mehrere Verstärkerstufen ersetzt werden. Bei einer Realisierung der Feldeffekttransistoren in N-Kanal-Technologie haben sämtliche Spannungen einschließlich der Versorgungsspannung $V_{DD}$ positive Vorzeiche, während für eine Realisierung in P-Kanal-Technologie negative Spannungen erforderlich sind.

Bevorzugte Anwendungsmöglichkeiten für erfindungsgemäße Integratorschaltungen ergeben sich bei monolithischen Filtern, wie sie beispielsweise in dem eingangs genannten Aufsatz aus dem IEEE Journal beschrieben sind.

**Patentansprüche**

1. Integratorschaltung mit einer oder mehreren Verstärkerstufen (4, 18), die mit einem eine Kapazität (C2) enthaltenden Rückkopplungszweig (9) versehen sind, und mit zwei synchron betätigbaren Polaritätsumschaltern (US1, US2), von denen der erste (US1) dem Eingang der ersten Verstärkerstufe (4) derart vorgeschaltet ist, daß der Rückkopplungszweig (9) über ihn verläuft, und der zweite (US2) am Ausgang einer der Verstärkerstufen (4) angeordnet ist, die als Differenzverstärker ausgebildet ist, der zwei mit einer gemeinsamen Stromquelle (25) beschaltete Verstärkerelemente (T7, T8) und zwei in Serie zu diesen liegende Lastelemente (22, 23) enthält, dadurch gekennzeichnet, daß eine eingangsseitige Abtaststufe (A) vorgesehen ist, die eine weitere Kapazität (C1) und elektronische Schalter (2, 3) aufweist, daß der erste Polaritätsumschalter (US1) dem Ausgang der Abtaststufe (1) nachgeschaltet ist, und daß parallel zu den Lastelementen (22, 23) wechselweise betätigbare Schalter (T13, T14) angeordnet sind.

2. Integratorschaltung mit einer oder mehreren Verstärkerstufen (4, 8), die mit einem eine Kapazität (C2) enthaltenden Rückkopplungszweig (9) versehen sind, und mit zwei synchron betätigbaren Polaritätsumschaltern (US1, US2), von denen der erste (US1) dem Eingang der ersten Verstärkerstufe (4) derart vorgeschaltet ist, daß der Rückkopplungszweig (9) über ihn verläuft, und der zweite (US2) am Ausgang einer der Verstärkerstufen (4) angeordnet ist, die als Differenzverstärker ausgebildet ist, der zwei mit einer gemeinsamen Stromquelle (25) beschaltete Verstärkerelemente (T7, T8) enthält, denen jeweils ein Lastelement (T21) in Serie zugeschaltet ist, dadurch gekennzeichnet, daß eine eingangsseiteige Abtaststufe (A) vorgesehen ist, die eine weitere Kapazität (C1) und elektronische Schalter (2, 3) aufweist, daß der erste Polaritätsumschalter (US1) dem Ausgang der Abtaststufe (1) nachgeschaltet ist, und daß der Differenzverstärker ein Lastelement (T21) enthält, das über ein erstes Schaltelement (T17) in Serie zu dem einen Verstärkerelement (T7) und über ein zweites Schaltelement (T19) in Serie zu dem zweiten Verstärkerelement (T8) liegt und daß jedes Verstärkerelement (T7, T8) über einen weiteren Schalter (T20, T18) mit einer Versorgungsspannungsquelle (24) verbunden ist.

3. Integratorschaltung nach Anspruch 1, dadurch gekennzeichnet, daß der zweite Polaritätsumschalter (US2) am Ausgang der ersten Verstärkerstufe (4) angeordnet ist.

4. Integratorschaltung nach einem der vorhergehenden Ansprüche, dadurch gekennzeichnet, daß der Polaritätsumschalter (US1, US2) aus Feldeffekttransistoren (T1 bis T4 ; T15, T16) gebildet ist, deren Source-Drain-Strecken in die Schaltereingänge mit den Schalterausgängen verbindenden Stromzweigen liegen.

**Claims**

1. An integrator circuit with one or more amplifier stages (4, 18) provided with a feedback arm (9) containing a capacitor (C2), and with two synchronously operable polarity change-over switches (US1, US2) of which the first (US1) is connected in series with the input of the first amplifier stage (4) in such manner that the feedback arm (9) runs across it, and the second (US2) is arranged at the output of one of the amplifier stages (4) which is designed as a differential amplifier containing two amplifier elements (T7, T8) which are wired to a common current source (25), and two load elements (22, 23) which are arranged in series with said amplifier elements, characterised in that at the input end a sampling stage (A) is provided which contains a further capacitor (C1) and electronic switches (2, 3), that the first polarity change-over switch (US1) is connected to the output of the sampling stage (1), and that alternately operable switches (T13, T14) are arranged parallel to the load elements (22, 23).

2. An integrator circuit having one or more amplifier stages (4, 8) provided with a feedback arm (9) which contains a capacitor (C2), and with two synchronously operable polarity change-over switches (US1, US2), of which the first (US1) is connected in series with the input of the first amplifier stage (4) in such mannner that the feedback arm (9) runs across it, and the second (US2) is arranged at the output of one of the amplifier stages (4) which is designed as a differential amplifier containing two amplifier elements (T7, T8) which are wired to a common current source (25) and each of which is connected in series with a load element (T21), characterised in that at the input end a sampling stage (A) is provided which contains a further capacitor (C1) and electronic switches (2, 3), that the first polarity change-over switch (US1) is connected following the output of the sampling stage (1), and that the differential amplifier contains a load element (T21) which is connected via a first switching element (T17) in series with the first amplifier element (T7) and via a second switching element (T19) in series with the second amplifier element (T8), and that each amplifier element (T7, T8) is connected via a further switch (T20, T18) to a supply voltage source (24).

3. An integrator circuit as claimed in Claim 1, characterised in that the second polarity change-over switch (US2) is arranged at the output of the first amplifier stage (4).

4. An integrator circuit as claimed in one of the preceding Claims, characterised in that the polarity change-over switch (US1, US2) consists of field effect transistors (T1 to T4 ; T15, T16) whose source-drain paths are located in current arms which connect the switch inputs to the switch outputs.

**Revendications**

1. Circuit intégrateur avec un ou plusieurs étages amplificateurs (4, 18) qui sont pourvus d'une boucle de contre-réaction (9) comportant une capacité (C2), et avec deux commutateurs d'inversion de polarité (US1, US2) susceptibles d'être commandés de façon synchrone, dont le premier (US1) est monté en aval du premier étage amplificateur (4) de manière à être traversé par la boucle de contre-réaction (9), et dont le second (US2) est disposé à la sortie de l'un des étages amplificateurs (4), réalisé sous la forme d'un amplificateur différentiel qui comporte deux éléments amplificateurs (17, 18) alimentés par une source de courant commune (25) et deux éléments de charge (22, 23) montés en série avec ces derniers, caractérisé par le fait qu'il est prévu un étage d'échantillonnage (A), situé côté entrée et comportant une capacité supplémentaire (C1) et des commutateurs électroniques (2, 3), que le premier commutateur d'inversion de polarité (US1) est monté en aval de la sortie de l'étage d'échantillonnage (1), et qu'en parallèle sur les éléments de charge (22, 23) sont montés des commutateurs (T13, T14) susceptibles d'être commandés de façon alternée.

2. Circuit intégrateur avec un ou plusieurs étages amplificateurs (4, 8) qui sont pourvus d'une boucle de contre-réaction (9) comportant une capacité (C2), et avec deux commutateurs d'inversion de polarité (US1, US2) susceptibles d'être commandés de façon synchrone, dont le premier (US1) est monté en aval du premier étage amplificateur (4) de manière à être traversé par la boucle de contre-réaction (9), et dont le second (US2) est disposé à la sortie de l'un des étages amplificateurs (4), réalisé sous la forme d'un amplificateur différentiel qui comporte deux éléments amplificateurs (17, 18) alimentés par une source de courant commune (25), et à chacun desquels est relié en série un élément de charge (T21), caractérisé par le fait qu'il est prévu, du côté entrée, un étage d'échantillonnage (A) comportant une capacité supplémentaire (C1) et des commutateurs électroniques (2, 3), que le premier commutateur d'inversion de polarité (US1) est monté en aval de la sortie de l'étage amplificateur (1), et que l'amplificateur différentiel comporte un élément de charge (T2) monté en série avec l'un (T7) des éléments amplificateurs, par l'intermédiaire d'un premier élément de commutation (T17) et en série avec le second élément amplificateur (T8), par l'intermédiaire d'un second élément de commutation (T19), et que chaque élément amplificateur (T7, T8) est relié, par l'intermédiaire d'un commutateur supplémentaire (T20, T18), à une source de tension d'alimentation (24).

3. Circuit intégrateur selon la revendication 1, caractérisé par le fait que le second commutateur d'inversion de polarité (US2) est disposé à la sortie du premier étage amplificateur (4).

4. Circuit intégrateur selon l'une des revendications précédentes, caractérisé par le fait que le commutateur d'inversion de polarité (US1, US2) est constitué par des transistors à effet de champ (T1 à T4 ; T15, T16), dont les circuits source-drain se situent dans les branches de passage du courant qui relient les entrées des commutateurs aux sorties des commutateurs.

## FIG 1

## FIG 2

$$u_{11}$$

$$V_R \cdot \frac{C1}{C2}$$

## FIG 3

$$u_{12}$$

$$V_R \cdot \frac{C1}{C2}$$

1

# FIG 4

# FIG 5

# FIG 6

FIG 7

FIG 8